# EUROPEAN PATENT SPECIFICATION

(11) **EP 0 512 618 B1**
(45) Date of publication and mention of the grant of the patent: **06.08.1997**
(21) Application number: 92201209.1
(22) Date of filing: 04.05.1992
(51) Int. Cl.: H04N 5/50

(54) **Television receiver including a search tuning circuit**
Fernsehempfänger mit einer Suchlaufschaltung
Télérécepteur muni d'un circuit de recherche d'émetteurs

(30) Priority: 10.05.1991 EP 91201133
(43) Date of publication of application: 11.11.1992
(73) Proprietor: Philips Electronics N.V., 5621 BA Eindhoven (NL)
(72) Inventor: Vaske, Bernardus Hermanus, NL-5656 AA Eindhoven (NL)
(74) Representative: Schoonheijm, Harry Barend

(56) References cited:
- EP-A- 0 409 562
- DE-A- 3 640 129

## Description

The invention relates to a television (TV) receiver including a search tuning circuit for automatically searching tuning data of TV programs in an RF television (RF TV) reception frequency range after a search activation signal, a tuning device for tuning the TV receiver to a TV program found by the search tuning circuit, and a preset programming device for manually storing said tuning data in a tuning memory at a location from which the tuning data is readable by operating a TV program preset key.

Such a tuning programming system for a TV receiver is known *per se* from the publication "Colour television tuning and control systems" of Philips Components, August 1989.

The known method of programming the program preset keys is carried out as follows.

A search activation signal is supplied from the preset programming device to the search tuning circuit which starts a program search in a given RF TV reception frequency range. The tuning frequency of the TV receiver is varied in one direction (for example, monotonically increasing) over said RF TV reception frequency range until a TV program having an acceptable reception quality is received. At that moment the search stops and the tuning data (*i.e*. the value of the tuning frequency or an analog or digital value corresponding thereto) of the TV program found is available.

The TV program signal is subsequently displayed, enabling the user to identify the TV program. After this program identification the user selects a program preset key under which he wants to store the TV program or a preset program number which he wants to assign to the TV program. Programming of the selected preset key or the selected program number is realised after a storage command to be given by the user, the last-mentioned tuning data being stored at a location in the tuning memory which corresponds to the selected preset key or the selected program number. Programming by means of a preset key is hereinafter also understood to mean assigning a preset program number to a TV program.

For programming a subsequent program preset key the search is continued by again applying a search activation signal from the preset programming device to the search tuning circuit. If a subsequent TV program signal having an acceptable reception quality is received after some time, the user repeats the afore-described programming operations, this time with a different program preset key.

This way of programming the preset keys does not only require some system knowledge but is also comparatively time-consuming.

It is an object of the invention to reduce the period of time required for programming the preset keys and to make programming easier for the user.

According to the invention a TV receiver of the type described in the opening paragraph is therefore characterized by an automatic storage of a tuning data found by the search tuning circuit in a buffer memory, which buffer memory supplies the tuning data to the tuning device after initiation of the preset programming device for tuning the TV receiver to and identifying the TV program corresponding to the tuning data, followed by said manual storage.

When the measure according to the invention is used, it is not necessary to postpone the continuation of the search until the user has finished programming a preset key, but it is possible to acquire tuning data independent of the instant of programming. This enables the user to tune the TV receiver to a subsequent TV program directly after ending the programming of a given preset key, identify this subsequent program and store its tuning data under a subsequent preset key.

The acquisition of tuning data and the program-sequential tuning of the receiver and program display for program identification can be performed with different tuning stages so that said acquisition can take place before and/or during programming the program preset keys. This provides the possibility of faster programming.

A preferred embodiment of a TV receiver according to the invention is therefore characterized in that the tuning device comprises first and second tuning stages *via* which first tuning stage the receiver is tuned for displaying a TV program signal and the second tuning stage is controlled by the search tuning circuit for searching the tuning data of at least one TV program in a TV frequency band and for storing it in the buffer memory.

This measure is particularly suitable for use in a picture-in-picture (PIP) TV receiver which has two tuning stages for PIP display of a second TV program signal in an inset in the picture area of a first TV program signal.

However, it is also possible to collect the tuning data of various TV programs succeeding each other in tuning frequency in an RF TV reception frequency range, subsequently store them in the buffer memory and then successively carry out said program identification and programming of the preset keys for each of these TV programs.

Another preferred embodiment of a TV receiver according to the invention is therefore characterized in that tuning data of various TV programs in an RF TV reception frequency range are automatically stored successively in the buffer memory, followed by a program-sequential identification and storage of said tuning data in the tuning memory.

The invention will be described in greater detail with reference to the Figures shown in the drawing. These Figures are used as examples for illustrating the invention. Elements mutually corresponding in function have the same reference indications.

In the Figures:
Fig. 1 shows a PIP TV receiver embodying the invention, having first and second tuning stages;
Figs. 2a and 2b show flow charts of a first method of programming preset keys in a PIP TV receiver according to Fig. 1;
Fig. 3 shows a flow chart of a second method of programming preset keys in a PIP TV receiver according to Fig. 1;
Fig. 4 shows a flow chart of a method of programming preset keys in a TV receiver according to the invention, having a single tuning stage.

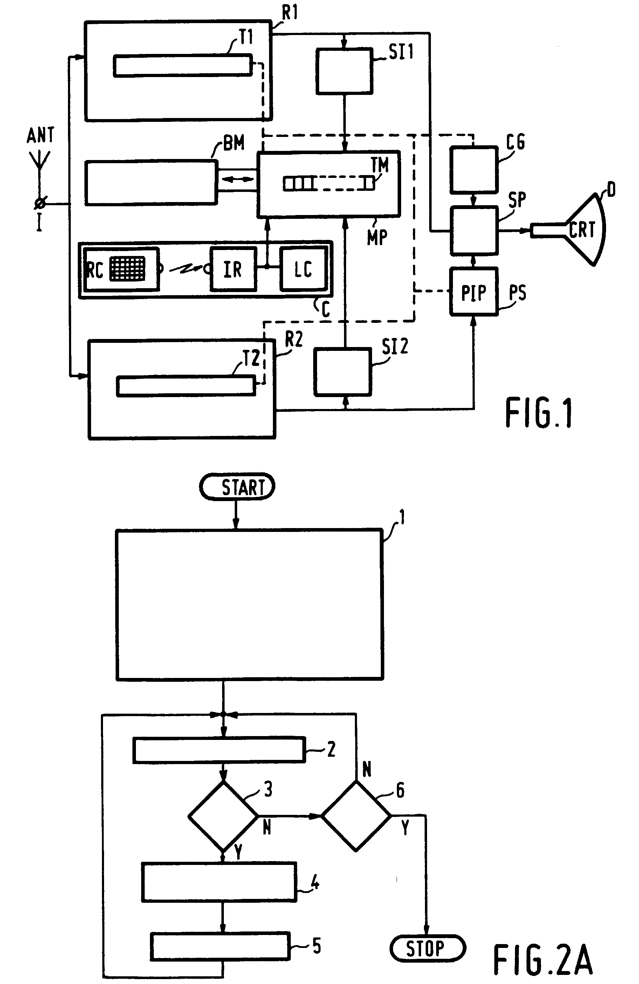

Fig. 1 shows a PIP TV receiver according to the invention, with an RF TV antenna input I for coupling a TV antenna device ANT thereto, first and second TV receiver sections R1 and R2 whose inputs are commonly connected to the RF TV antenna input I for the supply to each of the two TV receiver sections of an RF TV reception frequency range and having first and second tuners T1 and T2, respectively. An output of the first TV receiver section R1 is coupled to a first synchronization identification circuit SI1 and to a first input of a video signal processing circuit SP. An output of the second TV receiver section R2 is connected to an input of a second synchronization identification circuit SI2 and to an input of a PIP signal processing unit PS. An output of this PIP signal processing unit PS is connected to a second signal input of the video signal processing circuit SP. An output of SP is connected to a picture display device D.

Outputs of the first and second synchronization identification circuits SI1 and SI2 are coupled to a microprocessor circuit MP. Control signals for tuning and picture and volume control can be applied by a user to the microprocessor circuit MP by manually operating an operating device C. The operating device C comprises a local operating unit LC and a remote control unit IR, RC. The remote control unit RC, IR comprises an infrared transmitter RC and an infrared receiver IR. The operating units LC and RC have a number of N preset keys *via* which tuning data of a number of N TV programs can be addressed from a number of N memory locations of a tuning memory TM.

The microprocessor circuit MP is connected *via* a control signal bus to the first and the second TV receiver sections R1 and R2, to a character generator CG and to the PIP signal processing unit PS. An output of the character generator SG is connected to a third input of the video signal processing circuit SP. The microprocessor circuit MP comprises the afore-mentioned tuning memory TM and in the embodiment shown it is coupled to a buffer memory BM. The buffer memory BM may be incorporated in the microprocessor circuit MP.

The first and second TV receiver sections R1 and R2 can be tuned to first and second TV transmitter frequencies by means of the first and second tuners T1 and T2 and their TV program signals can be converted into first and second baseband video signals which are available at outputs of R1 and R2 for further signal processing. The first and second synchronization identification circuits SI1 and SI2 detect the presence of synchronizing pulses in the output signals of R1 and R2 and thereby identify a tuning to a transmitter frequency at which a TV program can be received correctly. When the presence of a TV program is recognized, the synchronization identification circuits SI1 and SI2 supply a binary identification signal of, for example, the value of 1 to the microprocessor circuit MP. The second baseband video signal at the output of R2 is scaled in the PIP signal processing unit PS and together with the first baseband video signal of R1 it is combined to a PIP picture signal in the video signal processing circuit SP. A display of this PIP picture signal results in an image of the first baseband video signal of R1 as a main picture on the display area of D and an image of the second baseband video signal of R2 in an inset in said main picture. Texts, for example menu texts instead of or in combination with the afore-mentioned PIP picture signal can be displayed by means of the display device D from the character generator SG.

The shown PIP TV receiver embodying the invention includes first and second search tuning circuits which are constituted by the microprocessor circuit MP in combination with the first and second tuners T1 and T2 in R1 and R2 and the synchronization identification circuits SI1 and SI2, respectively. A user can apply a search activation signal to the microprocessor circuit MP by operating the operating device C. As a result MP starts a search for TV programs in an RF TV reception frequency range, for example from an actual tuning frequency or from a fixed initiation tuning frequency which may be selected, for example at the lowest possible frequency of the lowest RF TV reception band. Starting from a search by means of, for example MP, R1 and SI1, an acquisition of tuning data of TV programs having an acceptable reception quality is realised in an RF TV reception frequency range by a continuous or step-wise variation of the tuning frequency of T1 until the synchronization identification circuit SI1 detects the presence of synchronizing pulses at the output of R1. At that moment the tuning data, *i.e*. the tuning frequency of the TV transmitter found is available and the search stops. The search is continued after a new search activation signal has been applied, which can be given automatically from MP or manually by the user from the operating device C.

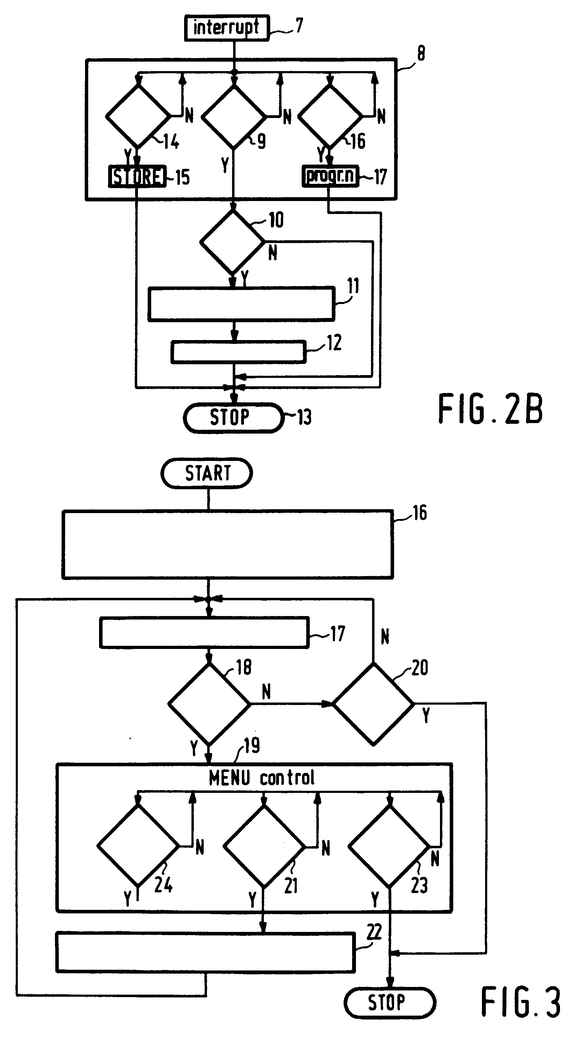

As already stated hereinbefore the tuning memory TM of MP has a number of memory locations for storing tuning data of preset TV programs. These memory locations correspond to and are operable by a user from program preset keys or program preset numbers. For assigning TV programs to these program preset keys or program preset numbers, *i.e*. for their programming in the TV PIP receiver according to the invention, reference is made to Figs. 2a and 2b.

Fig. 2a shows a flow chart of a method of reading tuning data of TV programs in the TV reception frequency range into the buffer memory BM. The buffer memory BM has a number of memory locations and write and read pointers (not shown) which are used to indicate a sequence in, respectively from which the memory locations of the buffer memory BM must be written or respectively read.

In this flow chart the microprocessor circuit MP performs a first step (1) after a programming start signal from the operating device C, in which step:
- the first and second TV receiver sections R1 and R2 are tuned and set to a lowest frequency in the lowest RF TV reception band;
- when an acceptable TV program signal is received with the TV receiver sections R1 and R2, the display mode of the PIP TV receiver is set in such a way that the TV program signal of the first TV receiver section R1 is displayed as the main picture and the signal of the second TV receiver section R2 is displayed in a sub-area of said main picture;
- the read and write pointers of the buffer memory BM are set to a reference position, for example 0;
- a search is activated by means of the first tuner TM, the first synchronization identification circuit SI1 and the microprocessor circuit MP;
- MP stops the search when a TV program having an acceptable reception quality is received, *i.e*. when tuning to an RF TV reception signal whose baseband video signal at the output of R1 comprises synchronizing pulses which are recognized by SI1;
- the tuning data of this TV program is subsequently stored at the memory location in the buffer memory BM which is indicated by the write pointer, in the relevant example at the memory location of the write address 0;
- the tuning data is also copied from R2 to T2 so that the picture signal of the last-mentioned TV program is displayed in the PIP image sub-area of the main picture;
- MP subsequently increments the write pointer which will now be at the write address 1 and MP subsequently starts a search by means of the second tuner T2 of the second TV receiver section R2 and the second synchronization identification circuit SI2.

In step 2 of the flow chart of Fig. 2a the search from MP is performed with R2 and SI2 because MP raises the tuning frequency of the second tuner T2. This search is effected until in step 3 a TV program with an acceptable reception quality is found again, this time with the aid of SI2. The search stops at that moment and in step 4 MP stores the tuning data of the last-mentioned transmitter in the buffer memory BM at a memory location indicated by the write pointer with write address 1. Subsequently the microprocessor circuit MP increments the write pointer in step 5 to the next write address, *i.e*. write address 2 and returns to said step 2. The search is automatically continued by MP until it is ascertained in step 6 that the maximum frequency of the RF TV reception range is reached whereafter the automatic acquisition and storage of tuning data of TV transmitters in the buffer memory BM is ended.

Fig. 2b shows a flow chart of a method by which the tuning data found in accordance with the afore-described method and stored in BM are transferred to the tuning memory TM. By means of what is referred to as an interrupt command the user can change over to this method already during the searching and storing action described with reference to the flow chart of Fig. 2a and in principle already after storing the first found transmitter.

In a practical embodiment of the PIP TV receiver according to the invention it is possible for the user to apply menu commands to the microprocessor circuit MP *via* the operating unit LC or RC, with which commands a menu text can be optically displayed on the picture display device D *via* the character generator SG. A menu text may comprise questions to which the user can react interactively by means of a bivalent operating signal and with which he can select a number of different setting options in a simple manner.

By means of said interrupt command the user can interrupt the afore-mentioned method (step 7) and call a program menu (step 8). One of the options/questions of this program menu, pictured by means of block 9, relates to displaying or not displaying the TV program whose tuning data is located at the address indicated by the read pointer in the buffer memory BM. To this end the menu text asks the user the question whether he wants to see the next picture. If the user answers with "Y" *via* his operating unit LC or RC to the microprocessor circuit MP, the tuning data at the address to which the read pointer in the buffer memory BM points will be transferred to the first tuner T1 of the first TV receiver section R1. The main picture now displays the TV program whose tuning data is stored at the memory location in BM with the address which is indicated by the read pointer. These operations take place in step 11 of the flow chart of Fig. 2b.

Subsequently the microprocessor circuit MP increments the read pointer to the address of the next memory location of BM to be read and, if desired, the user can realise a main picture display of the TV program in step 11 *via* said block 9 with an answer "Y", which TV program has its tuning data stored at the memory location of BM with the last-mentioned address.

After said step 11 the user can identify the TV program displayed as main picture in D and decide to store or not store the associated tuning data under a preset key to be selected by the user. To this end the programming menu in block 14 provides a storage option. By means of a "Y" answer the user can store, in step 15, the last-mentioned tuning data in the tuning memory TM at a memory location of TM which corresponds to a program preset key or preset program number to be selected by the user in a step 17 and to be indicated by manually operating the operating unit LC or RC. This manual storage in step 17 is possible after a "Y" answer by the user to an optional selection of a key or a number in block 16.

Fig. 3 shows a flow chart of a tuning programming method in which MP performs a search alternately with R1 and SI1 and with R2 and SI2, respectively, and which provides the possibility of using a buffer memory having only one memory location. The tuning data of the last-found TV program is stored in this single memory location. In practice this corresponds to the setting of the tuner with which tuning to the last-mentioned TV program has taken place during the last search. Since in this method the buffer memory BM only requires one location, the read and write pointers of the buffer memory BM can be dispensed with.

In a step 16 following the initiation of the tuning programming and indicated by a start block, the microprocessor circuit MP realises the same setting of the first and second TV receiver sections R1 and R2 as well as the same setting of the picture display and initiation of a search with MP, R1 and SI1 as that mentioned in step 1 of the flow chart of Fig. 2a, with the exception of the operations regarding the read and write pointers of the buffer memory BM, because these are now absent.
After a TV program has been found with T1 of R1, the setting of T1 and hence the tuning data of the last-mentioned TV program is retained in the buffer memory so that this TV program can be permanently displayed as the main picture in D. The setting of T1 is also copied from R2 to T2 and subsequently, in step 17, a continuation of the search is initiated, this time with R2 and SI2 from the RF TV reception frequency of the last-mentioned TV program.

After a further TV program has been found, the last-mentioned search performed with R2 and SI2 is automatically stopped and, in step 18, a menu control is released. *Via* this menu control the user can realise a main picture display of the last-mentioned further TV program for which purpose the setting is copied from T2 to T1.
Subsequently there is a return to step 17 in which a continuation of the search with T2 of R2 is initiated.

If after releasing the menu control the user decides to store the tuning data of the first-mentioned TV program shown as the main picture in D under a preset key or assign it to a preset program number, he should perform the afore-described programming steps 14-17.

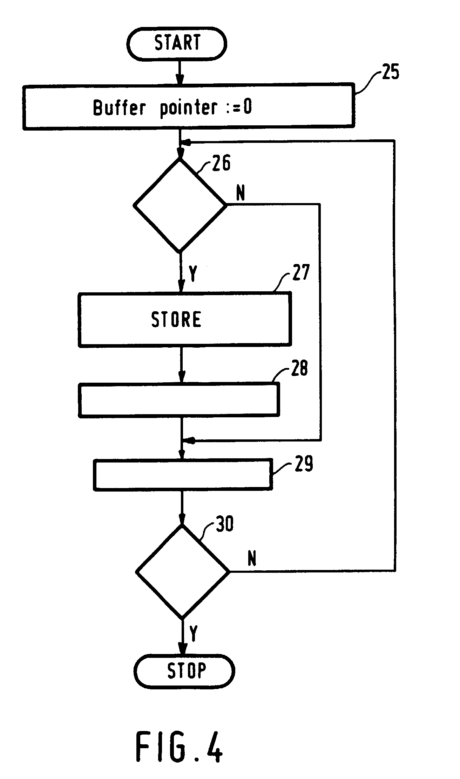

Fig. 4 shows a flow chart of the preset tuning programming method in a TV receiver according to the invention having only one tuning stage. Such a TV receiver corresponds to that of Fig. 1 without the circuits R2, SI2 and PS with a number of memory locations in the buffer memory BM which is at least equal to the number of memory locations of the tuning memory TM.

In such a TV receiver (not shown) the tuning programming is effected after the buffer memory BM is filled by means of a search performed with MP, R1 and SI1 with the tuning data of all TV programs in the entire receivable RF TV reception frequency range. This uninterrupted acquisition and buffer storage of tuning data can be performed silently after the user has given an initiating control signal to MP *via* a manual operation of the operating unit LC or RC.
Since the acquisition and buffer storage as a whole has already taken place before the tuning programming takes place, waiting periods during the tuning programming operation are avoided.

As mentioned hereinbefore, the acquisition and buffer storage of tuning data is started by the last-mentioned control signal, whereafter the microprocessor circuit MP sets the now sole TV receiver section R1 to the lowest RF TV transmitter frequency in the lowest TV reception band and the write pointer of the buffer memory BM at a reference address 0 as is shown in step 25. After a TV program has been received, the tuning data of this TV program is stored, in step 27, in the buffer memory BM at the location indicated by the write pointer. Subsequently the write pointer is incremented in step 28 and in a step 29 the search is continued. This method is repeated until the highest frequency in the TV reception band is reached and the acquisition and storage are discontinued. Subsequently MP releases a menu text *via* which the user can perform a tuning programming operation, for example in accordance with the method as indicated by means of steps 14-17 in the flow chart of Fig. 2b.

## Claims

1. A television receiver including a search tuning circuit (MP, T1, T2, SI₁, SI₂) for automatically searching tuning data of television programs in a television frequency band after a search activation signal, a tuning device (T₁, T₂) for tuning the television receiver to a television program found by the search tuning circuit, and a preset programming device (C, MP) for manually storing said tuning data in a tuning memory (TM) at a location from which the tuning data is readable by operating a program preset key, the receiver being characterized by including a buffer memory (BM) in which tuning data found by the search tuning circuit are automatically stored, which buffer memory, after initiation of the preset programming device, supplies the tuning data to the tuning device for tuning the television receiver to and identifying the television program corresponding to the tuning data, followed by said manual storage.

2. A television receiver as claimed in Claim 1, characterized in that the tuning device comprises first and second tuning stages (T₁, T₂) *via* which first tuning stage the receiver is tuned for displaying a television program signal and the second tuning stage is controlled by the search tuning circuit for searching the tuning data of at least one television program in a television frequency band and for storing it in the buffer memory.

3. A television receiver as claimed in Claim 1 or 2, characterized in that tuning data of various television programs in a television frequency band are automatically stored successively in the buffer memory, followed by a program-sequential identification and storage of said tuning data in the tuning memory.

4. A television receiver as claimed in Claim 2, characterized in that after initiating the preset programming device the buffer memory alternately supplies the tuning data sequentially read out from said buffer memory to the first and the second tuning stage.

## Patentansprüche

1. Fernsehempfänger mit einer Suchlaufschaltung (MP, T1, T2, SI11, SI2) zum automatischen Suchen von Abstimmdaten von Fernsehprogrammen in einem HF-Fernsehempfangsbereich nach einem Suchaktivierungssignal, mit einer Abstimmvorrichtung (T1, T2) zum Abstimmen des Fernsehempfängers auf ein von der Suchlaufschaltung gefundenes Fernsehprogramm, sowie mit einer Vorwahlprogrammierungsanordnung (C, MP) zur handmäßigen Speicherung dieser Abstimmdaten in einem Abstimmspeicher (TM) an einer Stelle, von woraus die Abstimmdaten aufrufbar sind durch Betätigung einer Fernsehprogramm-Vorwahlabstimmtaste, wobei dieser Empfänger dadurch gekennzeichnet ist, daß er einen Pufferspeicher (BM) aufweist, in dem von der Suchlaufabstimmschaltung erhaltene Abstimmdaten automatisch gespeichert werden, wobei dieser Pufferspeicher nach einem Start der Vorwahlprogrammierungsvorrichtung die Abstimmdaten zuführt, und zwar zu der Abstimmanordnung zur Abstimmung des Fernsehempfängers auf das den Abstimmdaten entsprechendes Fernsehprogramm und zur Identifizierung desselben, wobei diesem Vorgang die genannte handmäßige Speicherung folgt.

2. Fernsehempfänger nach Anspruch 1, dadurch gekennzeichnet, daß die Abstimmvorrichtung mit einer ersten und einer zweiten Abstimmstufe (T1, T2) versehen ist, wobei über die erste Abstimmstufe eine Abstimmung des Empfängers für eine Wiedergabe eines Fernsehprogrammsignals erfolgt und wobei die zweite Abstimmstufe durch die Suchlaufschaltung zum Suchen der Abstimmdaten wenigstens eines Fernsehprogramms in einem Fernsehfrequenzband und zum Speichern derselben in dem Pufferspeicher geregelt ist.

3. Fernsehempfänger nach Anspruch 1 oder 2, dadurch gekennzeichnet, daß in dem Pufferspeicher eine zwangsläufige Speicherung von Abstimmdaten mehrerer Fernsehprogramme in einem HF-Fernsehempfangsfrequenzbereich aufeinanderfolgend stattfindet mit einer nachfolgenden programmweisen Identifikation und Speicherung dieser Abstimmdaten in dem Abstimmspeicher.

4. Fernsehempfänger nach Anspruch 2, dadurch gekennzeichnet, daß der Pufferspeicher nach dem Start der Vorwahlprogrammierungsvorrichtung wechselweise die Abstimmdaten liefert, die aus dem genannten Pufferspeicher sequentiell ausgelesen werden.

## Revendications

1. Récepteur de télévision comprenant un circuit de recherche d'émetteurs (MP, T1, T2, SI1, SI2) pour rechercher automatiquement des données d'accord de programmes TV dans une plage de fréquences de télévision RF (TV RF) après un signal d'activation de recherche, un dispositif d'accord (T1, T2) pour accorder le récepteur TV sur un programme TV trouvé par le circuit de recherche d'émetteurs et un dispositif de programmation préréglé (C, MP) pour stocker manuellement lesdites données d'accord dans une mémoire d'accord (TM), dans un emplacement où les données d'accord peuvent être lues en actionnant une touche préréglée de programme TV, le récepteur étant caractérisé en ce qu'il comprend une mémoire tampon (BM) dans laquelle les données d'accord trouvées par le circuit de recherche d'émetteurs sont automatiquement stockées, ladite mémoire tampon délivrant les données d'accord au dispositif d'accord, après lancement du dispositif de programmation préréglé, pour accorder le récepteur TV sur les données d'accord et identifier le programme TV correspondant à celles-ci, le tout étant suivi dudit stockage manuel.

2. Récepteur de télévision selon la revendication 1, caractérisé en ce que le dispositif d'accord comprend un premier et un deuxième étages d'accord (T1, T2), ledit premier étage d'accord permettant l'accord du récepteur pour afficher un signal de programme TV et le deuxième étage d'accord étant commandé par le circuit de recherche d'émetteurs pour rechercher les données d'accord d'au moins un programme TV dans une bande de fréquences TV et pour les stocker dans la mémoire tampon.

3. Récepteur de télévision selon la revendication 1 ou 2, caractérisé en ce que les données d'accord de divers programmes TV dans une plage de fréquences de télévision sont automatiquement stockées successivement dans la mémoire tampon, le tout étant suivi de l'identification séquentielle de programmes et du stockage desdites données d'accord dans la mémoire d'accord.

4. Récepteur de télévision selon la revendication 2, caractérisé en ce que, après lancement du dispositif de programmation préréglé, la mémoire tampon délivre en alternance les données d'accord extraites en séquence de ladite mémoire tampon au premier et au deuxième étages d'accord.
